# EUROPEAN PATENT APPLICATION

(11) **EP 0 793 265 A2**
(43) Date of publication of application: **03.09.1997**
(21) Application number: 97201298.3
(22) Date of filing: 09.03.1993
(51) Int. Cl.: H01L 21/28, H01L 21/321

(54) **Method of processing a polysilicon film**

(30) Priority: 09.03.1992 JP 50218/92
(62) Divisional of application: 93301775.8
(71) Applicant: NEC CORPORATION, Tokyo (JP)
(72) Inventor: Shimizu, Junzoh, Minato-ku, Tokyo (JP)
(74) Representative: Cozens, Paul Dennis

(57) **Abstract**

A method of processing a polysilicon film formed on a single-crystal silicon substrate which can remove the polysilicon film with good selectivity in a fabrication process of semiconductor devices. First, a polysilicon film having an N-portion to be removed is formed on a single-crystal silicon substrate and then, the portion is selectively removed by the reactive ion etching using a Cl₂ gas or mixed gases including a Cl₂ gas. Preferably, N-impurity doping into the polysilicon film is performed by P or As ion-implantation with a dose of 1 x 10¹⁵ cm⁻² or more. A Cl₂ gas, mixed gases of Cl₂ and BCl₃, mixed gases of Cl₂ and HBr, mixed gases of Cl₂ and BBr₃, and mixed gases of Cl₂ and SiCl₄ are preferably used.

## Description

This invention relates to a method of manufacturing a semiconductor device such as a bipolar transistor or a MOS transistor.

As used herein, the term "substrate" includes any form of layer, regardless of its thickness or of its position in the overall semiconductor structure.

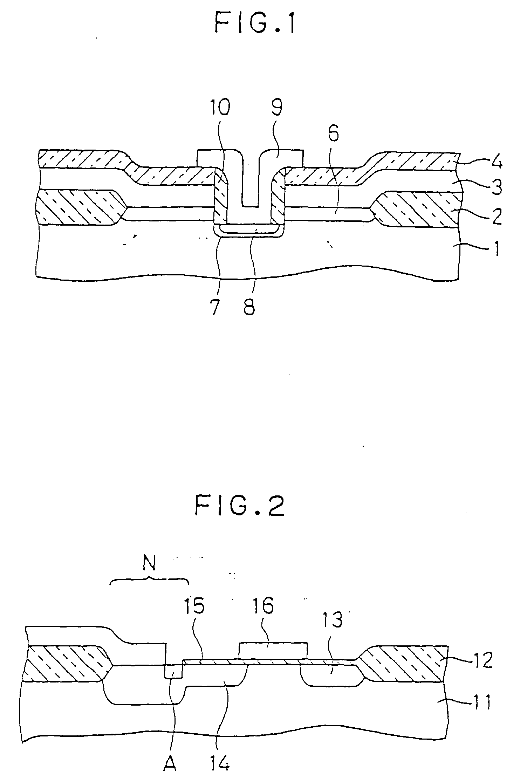

Recently, a selective etching technique of a polysilicon film on a single-crystal silicon substrate has become very important in Large Scale Integrated circuit (LSI) fabrication. The technique is used for forming an emitter opening in fabricating a bipolar transistor having a polysilicon base electrode connected to a graft base. This technique will be described in more detail with reference to figure 1, which shows a step in the fabrication process of a bipolar transistor in which the above-described conventional technique is used.

In figure 1, silicon dioxide films 2 for isolation are formed on a single-crystal silicon substrate 1 by selective oxidisation. On the surfaces of the films 2 and the exposed surface of the substrate 1, a P⁺-polysilicon film 3 having a thickness of 200 to 300 nm is deposited, and on the film 3 a silicon dioxide film 4 having a thickness of 200 to 300 nm is deposited.

In an active region formed by the oxide films 2 of the substrate 1, a graft base area 6 is formed near the surface of the substrate 1 and an emitter opening is formed in the oxide film 4 and the polysilicon film 3. The polysilicon film 3 is patterned to form a base electrode.

An N-emitter region 8 and a P-active base region 7 are formed in a portion of the substrate which is facing the emitter opening. In the emitter opening, a sidewall 10 of a silicon dioxide film is formed on the side surfaces of the polysilicon film 3 and the silicon dioxide film 4, and an emitter electrode 9 of an N⁺-polysilicon film is formed on the surfaces of the sidewall 10, the emitter region 8 and the silicon dioxide film 4.

The bottom end of the emitter opening should be positioned at a level which is almost the same as that of the substrate 1 (or the graft base region 6) so that the graft base region 6 and the active base region 7 may be connected to each other. However, in figure 1, the bottom end of the emitter opening is positioned near the bottom end of the graft base region 6 due to over-etching. In addition, the bottom end of the spacer 10 is nearly extended to the bottom end of the graft base region 6.

In the process of forming the emitter opening, first, an unmasked portion of the silicon dioxide film 4 is selectively removed by an anisotropic etching technique such as the Reactive Ion Etching (RIE) technique using a fluorine gas or the like, and thereafter a portion of the polysilicon film 3 thus exposed is selectively removed by an anisotropic etching techniques such as the RIE technique using a chlorine gas or the like.

In this process, it is impossible to etch one of the P⁺-polysilicon film 3 and the single-crystal silicon substrate 1 selectively. Besides, it is extremely difficult to etch the polysilicon film 3 without etching the substrate 1 with regard to the present etching rate stability and etching uniformity. Accordingly, the polysilicon film 3 tends to remain partially on the substrate 1 due to insufficient etching, or the substrate 1 tends to be over-etched.

If the polysilicon film 3 remains partially on the substrate 1, there arises the problem that the emitter region 8 and the graft base region 6 are short-circuited with each other through the remainder of the film 3.

If the substrate 1 is over-etched, sufficient interconnections between the graft base region 6 and the active base region 7 cannot be obtained, as shown in figure 1, and, as a result, there arises the problem that base resistance will increase and punch through between the emitter region 6 and a collector region (not shown) will occur.

The above-described process of selective etching of the polysilicon film is also used in a process of forming a node portion of a memory cell of a static random access memory (SRAM) composed of MOS transistors.

Figure 2 shows a step in the fabrication process of an SRAM in which the above-described conventional etching technique is used.

As shown in figure 2, silicon dioxide films 12 for isolation are formed on a single-crystal silicon substrate 11 by selective oxidisation. In an active region formed by the oxide films 12 of the substrate 11, the surface area of the substrate 11 is covered with a silicon dioxide film 15 as a gate insulator. The film 15 is selectively removed at a node portion N of an SRAM memory cell. A gate electrode 16 of a N⁺-polysilicon film is formed on the film 15. A source region 13 and a drain region 14 are formed in the substrate 11 in self-alignment with respect to the gate electrode 16. The surface of the substrate 11 is partially exposed from the film 15 at the node portion N, and at the exposed area of the substrate 11, a concavity A is formed by etching.

The reason for the concavity A being formed is as follows: during the selective etching process of the polysilicon film to form the gate electrode 15, etching action affects the exposed surface area of the substrate 7. Besides, the etching rate of the phosphorus diffusion region in the substrate 11, that is the source region 13 and the drain region 14 in figure 2, is larger than that of the other region. Therefore, the exposed surface area of the substrate 7 at the node portion N is easily etched.

Since the concavity A induces crystal defects in the substrate 7, there arises the problem that minute node leakage may occur to degrade the data storage characteristics of the SRAM.

In accordance with a first aspect of the present invention, there is provided a method of manufacturing a semiconductor device, said method comprising the steps of:- forming a polysilicon film on or over a surface of a semiconductor substrate; characterised by the further steps of:- doping said polysilicon film with a P-type impurity; forming a mask layer on the P-type polysilicon film, said mask layer having a hole to expose a part of said P-type polysilicon film; introducing an N-type impurity into said part of said P-type polysilicon film through said hole, thereby converting said part into an N-type part; and selectively removing said N-type part of said polysilicon film by etching using said mask layer to make a hole in said polysilicon film.

In accordance with a second aspect of the present invention, there is provided a method of manufacturing a semiconductor device comprising the steps of: depositing a polysilicon film on a silicon substrate in contact therewith, said polysilicon film being doped with a P-type impurity to thereby represent a P-type property; forming a mask layer on said P-type polysilicon film, said mask layer having a first hole (or opening or window) to expose a portion of said P-type polysilicon film; introducing an N-type impurity into said portion of said P-type polysilicon film to convert the conductivity type of said portion of said polysilicon film into an N-type, thereby forming an N-type portion in said P-type polysilicon film; and selectively etching said N-type portion of said P-type polysilicon film using said mask layer to thereby expose a part of said silicon substrate; wherein etching-away of said exposed part of said silicon substrate during said selective etching step is suppressed as compared with a case where said N-type portion is not formed in said P-type polysilicon film and said P-type polysilicon film is selectively etched.

Preferably, said N-type impurity is doped to a depth slightly less than the depth of said surface of said substrate. Preferably, ion implantation is employed in said step of introducing said N-type impurity into said part of said P-type polysilicon film. In this case, ion implantation of one of phosphorus and arsenic ions is preferably employed, with a dose of at least 10¹⁵ cm⁻², and preferably the implantation energy is set in the range 40 to 50 keV.

The step of selectively removing said N-type part of said polysilicon film is preferably performed by a reactive ion etching using a gas selected from the group consisting of a Cl₂ gas, mixed gases of Cl₂ and BCl₃, mixed gases of Cl₂ and HBr, mixed gases of Cl₂ and BBr₃, and mixed gases of Cl₂ and SiCl₄.

The substrate is preferably formed from single crystal silicon, and the etch rate of said N-type part of said P-type polysilicon film may be 1.5 to 2 times faster than that of said substrate.

The polysilicon film may form a P-base electrode of a bipolar transistor, with said N-type part of said P-type polysilicon film being removed for forming an emitter opening.

The method may further comprise the steps of:- selectively introducing a P-type impurity into said substrate to form a P-graft base region of a bipolar transistor at an area surrounding said hole in said polysilicon film; selectively introducing a P-type impurity into said substrate to form a P-active base region of said bipolar transistor through said hole in said polysilicon film, said P-active base region being connected to said P-graft base region; making a sidewall spacer on a side fade of said polysilicon film in said hole in said polysilicon film; and selectively introducing an N-type impurity into said P-active base region to form an N-emitter region of said bipolar transistor using said sidewall spacer; wherein an etching rate of said N-type part of said P-type polysilicon film is higher than that of said P-type polysilicon film itself during said step of removing said N-type part of said P-type polysilicon film and therefore said N-type part of said P-type polysilicon film is selectively etched without overetching of said substrate.

The polysilicon film may form a gate electrode of a MOS transistor, with said N-type part of said polysilicon film being removed for forming a node portion of an MOS-RAM.

According to a third aspect of the invention, there is provided a method of processing a polysilicon film, comprising a step for preparing on a single-crystal silicon substrate a polysilicon film which has an N-portion to be removed, and a step of selectively removing the portion by the reactive ion etching technique using a chlorine gas, or gases including a chlorine gas.

With the method of the present invention, the etching rate of N-polysilicon can be made 1.5 to 2 times faster than that of P- or I- (no impurity-doped) polysilicon or single-crystal silicon, so that only the N-portion of the polysilicon film may be removed by the etching without the substrate being affected adversely. As a result, the polysilicon film can be processed with good selectively.

The substrate may be N-, P- or I-single-crystal silicon.

Preferably, the step of preparing the polysilicon film is realised by forming a P- or I- polysilicon film on the substrate and doping N-impurity into the entirety or part of the polysilicon film. This step may be performed by forming on the substrate a polysilicon film in which N-impurity is entirely or partially doped.

The impurity concentration of the N-portion of the polysilicon film may be set according to the necessary conditions for etching.

Preferably, N-impurity doping into the polysilicon film is performed by phosphorus or arsenic (or possibly phosphorus and arsenic) ion-implementation with a dose of 10¹⁵ cm⁻² or more.

In the step of selectively removing the portion, the selective ion etching may be performed under the ordinary condition.

As the etching gas, the following gas or mixed gases may be used: chlorine gas; mixed gases of chlorine and boron chloride; mixed gases of chlorine and hydrogen bromide; mixed gases of chlorine and boron bromide; and mixed gases of chloride and silicon chloride.

In a preferred embodiment, the polysilicon film forms a P-base electrode of a bipolar transistor and the N-portion of the polysilicon film is a portion to be removed for forming an emitter opening.

In another preferred embodiment, the polysilicon film forms a gate electrode of an MOS transistor and the N-type part of the polysilicon film is a portion where a node of an MOS-RAM is to be formed.

Preferred features of the invention are described in the following description, by way of example, with reference to the accompanying drawings, in which:
Figure 1 is a cross-sectional view of a bipolar transistor in which an emitter opening is formed by a conventional etching method;
Figure 2 is a cross-sectional view of a MOS transistor of a CMOS-SRAM in which a gate oxide film is selectively removed at a node portion by a conventional etching method;
Figures 3A to 3D are cross-sectional views showing a method of processing a polysilicon film according to the present invention; and
Figures 4A to 4C are cross-sectional views showing another method of processing a polysilicon film.

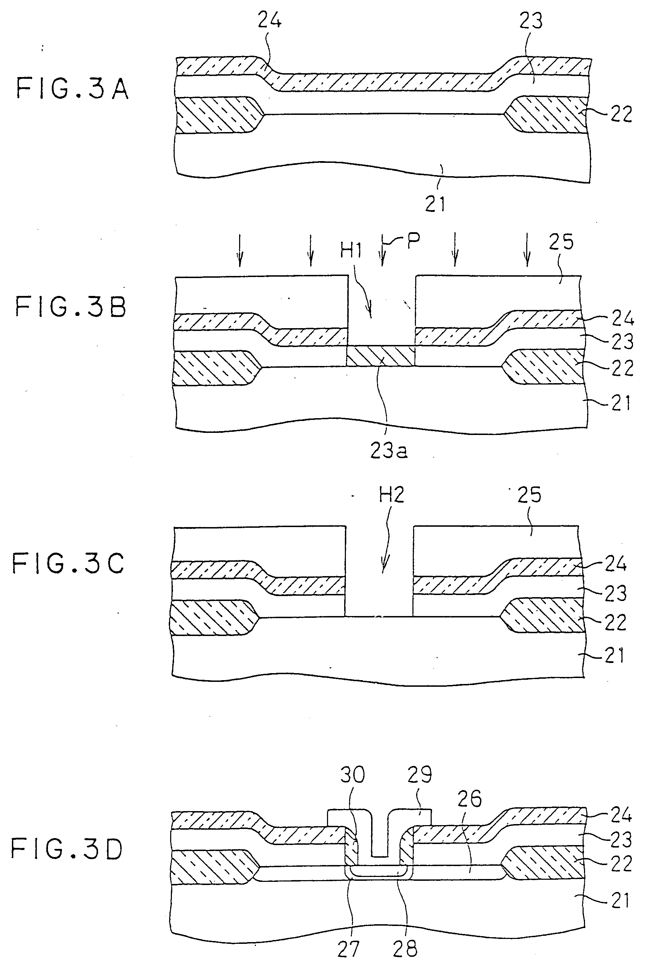

Figs. 3A to 3D show a fabrication process of a bipolar transistor using a method of processing a polysilicon film according to the present invention.

First, as shown in Fig. 3A, a surface or a single-crystal silicon substrate 21 is selectively oxidized to form silicon dioxide (SiO₂) films 22 for device isolation an the surface. Then, a polysilicon film 23 having a thickness of 100 to 200 nm is formed on the surface of the oxide films 22 and the exposed surface of the substrate 21 and, thereafter, the polysilicon film 23 is patterned so as to from a base electrode.

After boron (B) or boron fluoride (BF₂) is ion-implanted into the entire polysilicon film 23 to make it P⁺-type, a silicon dioxide film 24 having a thickness of 200 to 300 nm is formed on the film 23 by the chemical vapor deposition (CVD) technique.

Next, as shod in Fig. 3B, a photoresist film 25 with a hole H1 is formed on the oxide film 24 to form an emitter region, and the oxide film 24 is selectively removed to expose the surface of the P⁺-polysilicon film 23 by the anisotropic etching technique using the photoresist film 25 as a mask.

Subsequently, Phosphorus (P) is selectively ion-implanted into a portion 23a facing the opening H1 of the polysilicon film 23 to make it N-type using the same film 25 as a mask. In this process, the appropriate energy and dose of the ion-implantation vary dependent on the thickness of the P⁺-polysilicon film 23. For example, in the case of the thickness of the film 23 being 200 nm, the appropriate energy ranges from 40 to 50 keV and the appropriate dose ranges from 1 x 10¹⁵ to 5 x 10¹⁵ cm⁻². If ion-implantation Is performed under the above conditions, implanted ions are distributed in the portion 23a and its neighboring area, and the depth of the ion-distributed range is slightly smaller than the thickness of the film 23. Besides, the ion concentration in the portion 23a becomes 5 x 10¹⁹ cm⁻³ or more.

Arsenic (As) may be ion-implanted in place of Phosphorus. Which ion is to be used is determined according to the thickness of the polysilicon film 23.

The N⁺-portion 23a thus ion-implanted is then removed selectively by the reactive ion etching technique, using a Cl₂ gas or mixed gases including a Cl₂ gas, thereby to form a hole H2 extending to the surface of the substrate 21. The hole H2 is an emitter opening. The bottom end of the hole H2 is positioned at almost the same level of the surface of the substrate 21, and does not enter into the substrate 21 as shown in Fig. 1.

Since the ion concentration in the N⁺-portion 23a of the polysilicon film 23 is 5 x 10¹⁹ cm⁻³ or more, the etching rate of the portion 23a can be made 1.5 to 2 times faster than that of the single-crystal silicon substrate 21, so that only the portion 23a can be removed by the etching process without the substrate 21 being affected adversely. As a result, the polysilicon film 23 can be removed with good selectivity even if the etching rate dispersion is large and/or etching uniformity is bad.

For example, in case of the etching uniformity in a surface being ±10 %, substantial etching dispersion can be made within ±3 %.

Next, P-impurities are selectively doped into the substrate 21 to form a P⁺-graft base region 26 by diffusion from the inside of the P⁺-polysilicon film 23 or ion-implantation through the film 23, as shown in Fig. 3D.

P-impurities are doped through the hole H2 into the substrate 21 to form a P-active base region 27 and, thereafter, a sidewall 30 of silicon dioxide is formed on the side surfaces of the polysilicon film 23 and the silicon dioxide film 24.

Then, N-impurities are doped selectively through the hole H2 into the P-active base region 27 to form an N-emitter region 28, as shown in Fig. 3D, and an emitter electrode 29 connected to the N-emitter region 28 is formed in the sidewall 30. The top end of the emitter electrode 29 is placed on the surface of the silicon dioxide film 24.

With the bipolar transistor thus fabricated, due to good etching selectivity, the polysilicon film 23 does not remain on the substrate 21 and also the bottom end of the emitter opening H2 is positioned at almost the same level of the surface of the substrate 21, so that the graft base region 26 and the active base region 27 are well connected to each other. As a result, the problems generated in the conventional method such as base resistance increase and punch through between the emitter and collector regions do not arise.

Fabricating bipolar transistors using the method of the embodiment as a test, it was found that almost 100 % yield was obtained in the emitter opening forming process.

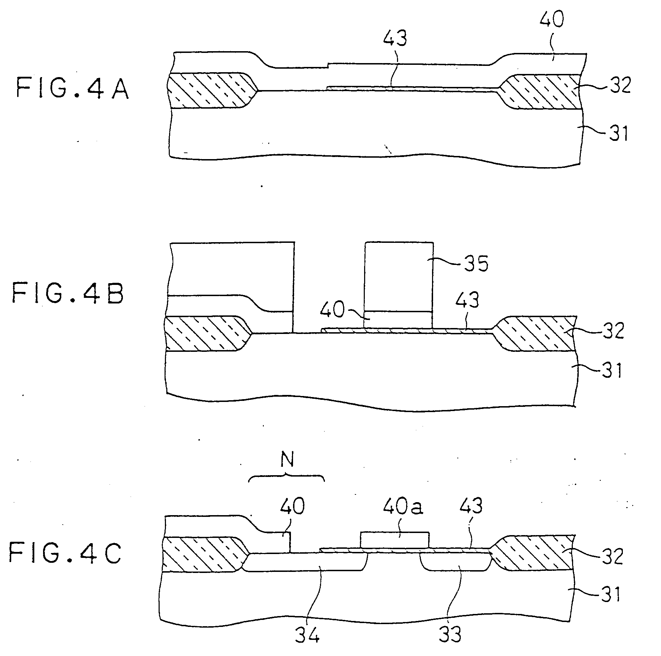

Figs. 4A to 4C show a fabrication process for a CMOS-SRAM using a method of processing a polysilicon film.

First, a surface of a single-crystal silicon substrate 31 is selectively oxidized to form silicon dioxide (SiO₂) films 32 for device isolation on the surface. Then, a gate oxide film 43 having a thickness of 10 to 20 nm is formed on an exposed surface of the substrate 31.

Next, the gate oxide film 43 is partially removed to form a node portion N and a polysilicon film 40 having a thickness of 100 to 200 nm for a gate electrode is formed on the entire surface of the substrate 31.

P or As is ion-implanted into the polysilicon film 40 to make the film 40 N⁺-type, as shown in Fig. 4A. The ion-implantation condition is set so that the ions may not be deeply implanted into the film 40. That is, the implantation energy is set in the range from 20 to 30 keV in the case of P and from 30 to 50 keV in the case of As, and the dose is set as 1 x 10¹⁵ cm⁻² or more in both cases.

Heat treatment at a low temperature of 700 to 800 °C is performed to diffuse the implanted P or As ions in the polysilicon film 40. In this case, since the diffusion coefficient of the P or As ions in polysilicon is larger than that in single-crystal silicon, the ions diffuse uniformly in the polysilicon film 40 without diffusing into the single-crystal silicon substrate 31.

A photoresist film 35 is formed on the N⁺-polysilicon film 40 and patterned as shown in Fig. 4B. Then, reactive ion etching of the film 40 in a Cl₂ gas or mixed gases including a Cl₂ gas is performed using the patterned photoresist film 35 as a mask to form a gate electrode 40a.

Also in this method, the etching rate of N⁺-polysilicon can be made 1.5 to 2 times faster than that of single-crystal silicon, so that only a portion to be removed of the film 40 may be selectively removed by the etching process without such a concavity as shown in Fig. 2 on the substrate 21.

Thereafter, as shown in Fig. 4C, a source region 33 and a drain region 34 are formed in self-alignment in the substrate 31 by the ion-implantation process as well as the P or As ions doped into the polysilicon film 40 are diffused into the node portion N in the substrate 31.

With the SRAM thus obtained, due to good etching selectivity, no concavity is formed in the substrate 31 and as a result, the problem generated in the conventional method such as minute node leakage does not arise.

Fabricating a CMOS-SRAM of a high load resistance or a thin film transistor (TFT) types using this method as a test, it was found that no scattered node leakage was generated and, as a result, fabrication yield of good quality devices was improved by approximately 10 % in the node portion forming process.

In the above embodiment, the method of the present invention is applied to a bipolar transistor; however, the present invention can be applied to other semiconductor devices.

It will be understood that the invention has been described above purely by way of example, and modifications of detail can be made within the scope of the invention.

## Claims

1. A method of manufacturing a semiconductor device, said method comprising the steps of:-
forming a polysilicon film (23) on or over a surface of a semiconductor substrate (21);
characterised by the further steps of:-
doping said polysilicon film with a P-type impurity; forming a mask layer (25) on the P-type polysilicon film, said mask layer having a hole (H1) to expose a part (23a) of said P-type polysilicon film;
introducing an N-type impurity into said part (23a) of said P-type polysilicon film through said hole (H1), thereby converting said part (23a) into an N-type part; and
selectively removing said N-type part of said polysilicon film by etching using said mask layer to make a hole (H2) in said polysilicon film.

2. A method of manufacturing a semiconductor device comprising the steps of:
depositing a polysilicon film on a silicon substrate in contact therewith, said polysilicon film being doped with a P-type impurity to thereby represent a P-type property;
forming a mask layer on said P-type polysilicon film, said mask layer having a first hole (or opening or window) to expose a portion of said P-type polysilicon film;
introducing an N-type impurity into said portion of said P-type polysilicon film to convert the conductivity type of said portion of said polysilicon film into an N-type, thereby forming an N-type portion in said P-type polysilicon film; and
selectively etching said N-type portion of said P-type polysilicon film using said mask layer to thereby expose a part of said silicon substrate;
wherein etching-away of said exposed part of said silicon substrate during said selective etching step is suppressed as compared with a case where said N-type portion is not formed in said P-type polysilicon film and said P-type polysilicon film is selectively etched.

3. A method according to Claim 1 or Claim 2, wherein said N-type impurity is doped to a depth slightly less than the depth of said surface of said substrate.

4. A method according to Claim 1, 2 or 3, wherein ion implantation is employed in said step of introducing said N-type impurity into said part (23a) of said P-type polysilicon film.

5. A method according to Claim 4, wherein ion implantation of one of phosphorus and arsenic ions is employed, with a dose of at least 10¹⁵ cm⁻².

6. A method according to Claim 5, wherein the implantation energy is set in the range 40 to 50 keV.

7. A method according to any of the preceding claims wherein said step of selectively removing said N-type part of said polysilicon film is performed by a reactive ion etching using a gas selected from the group consisting of a Cl₂ gas, mixed gases of Cl₂ and BCl₃, mixed gases of Cl₂ and HBr, mixed gases of Cl₂ and BBr₃, and mixed gases of Cl₂ and SiCl₄.

8. A method according to any of the preceding claims wherein the substrate is formed from single crystal silicon, and the etch rate of said N-type part of said P-type polysilicon film is 1.5 to 2 times faster than that of said substrate.

9. A method according to any one of the preceding claims, wherein said polysilicon film (23) forms a P-base electrode of a bipolar transistor and said
N-type of said P-type polysilicon film is removed for forming an emitter opening (H2).

10. A method according to any of one of Claims 1 to 8, wherein said polysilicon film (40) forms a gate electrode (40a) of a MOS transistor and said N-type part of said polysilicon film is removed for forming a node portion (N) of an MOS-RAM.

11. A method according to any of Claims 1 to 9, further comprising the steps of:-
selectively introducing a P-type impurity into said substrate to form a P-graft base region (26) of a bipolar transistor at an area surrounding said hole in said polysilicon film;
selectively introducing a P-type impurity into said substrate to form a P-active base region (27) of said bipolar transistor through said hole in said polysilicon film, said P-active base region being connected to said P-graft base region;
making a sidewall spacer (30) on a side face of said polysilicon film (23) in said hole in said polysilicon film; and
selectively introducing an N-type impurity into said P-active base region to form an N-emitter region (28) of said bipolar transistor using said sidewall spacer;
wherein an etching rate of said N-type part of said P-type polysilicon film is higher than that of said P-type polysilicon film itself during said step of removing said N-type part of said P-type polysilicon film and therefore said N-type part of said P-type polysilicon film is selectively etched without overetching of said substrate.
